# EUROPÄISCHE PATENTANMELDUNG

(11) **EP 2 175 483 A2**
(43) Veröffentlichungstag der Anmeldung: **14.04.2010**
(21) Anmeldenummer: 09010149.4
(22) Anmeldetag: 06.08.2009
(51) Int. Cl.: H01L 21/683

(54) **Vorrichtung zur Halterung einer Halbleiterscheibe und Verfahren zu deren Verwendung**

(30) Priorität: 09.10.2008 DE 102008051138; 20.03.2009 DE 102009014208
(71) Anmelder: SEMIKRON Elektronik GmbH & Co. KG, 90431 Nürnberg (DE)
(72) Erfinder: Müller, Gerhard, 90592 Schwarzenbruck (DE); Klaede, Carsten, 90766 Fürth (DE); Jost, Jakob, 90579 Langenzenn (DE); Koppi, Herbert, 90431 Nürnberg (DE)

(57) **Zusammenfassung**

Die Erfindung beschreibt eine Vorrichtung zur Halterung einer runden oder rechteckigen Halbleiterscheibe mit einer an die Dimensionen dieser Halbleiterscheibe angepassten planen Oberfläche. Hierbei weist diese Oberfläche mindestens drei konzentrisch angeordnete Hauptkanäle auf, die von der Halbleiterscheibe überdeckbar angeordnet sind, wobei jeder dieser Hauptkanäle unabhängig von den anderen Hauptkanälen mit einer Vakuumpumpeinrichtung verbindbar ist. Weiterhin wird ein Verfahren zur Verwendung der Vorrichtung vorgestellt, wobei zur Halterung der Halbleiterscheibe die Hauptkanäle beginnend mit dem dem Mittelpunkt nächstgelegenen Hauptkanal mit der Vakuumpumpeinrichtung verbunden wird und im Weiteren der jeweils nächstliegenden Hauptkanal (4) mit der Vakuumpumpeinrichtung verbunden wird bis alle Hauptkanäle mit der Vakuumpumpeneinrichtung verbunden sind.

## Beschreibung

Die Erfindung beschreibt eine Vorrichtung zur Halterung einer runden oder rechteckigen Halbleiterscheibe, sowie ein Verfahren zur Verwendung dieser Vorrichtung. Für die Herstellung von integrierten Schaltungen sowie von Leistungshalbleiterbauelementen sind runde Halbleiterscheiben mit verschiedenen Durchmessern, häufig zwischen 150mm und 300mm bekannt. Derartige Halbleiterscheiben weisen typische Dicken von einigen hundert Mikrometern bis unterhalb von einhundert Mikrometern auf. Aus der Herstellung von Solarzellen sind bevorzugt rechteckige oder quadratische Halbleiterscheiben bekannt, da durch diese Geometrie Solarpanels mit höherem Flächennutzungsgrad hergestellt werden können.

Seit langem bekannt sind Vorrichtungen mit einer planen Oberfläche und konzentrischen Kanälen hierin, die mittels einer Vakuumpumpeinrichtung die auf dieser Oberfläche angeordneten Halbleiterscheiben ansaugen und somit auf dieser Oberfläche fixieren. Derartig Vorrichtungen werden in verschiedenen Schritten der Bearbeitung der Halbleiterscheiben benötigt, um ein Verrutschen zu vermeiden. Nachteilig, speziell bei im Vergleich zu ihrem Durchmesser besonders dünnen Halbleiterscheiben, ist, dass diese nicht mehr ausreichend stabil sind und somit eine vollständig plane Auflage auf der Oberfläche nicht immer sicher gewährleistet ist.

Der Erfindung liegt die Aufgabe zugrunde die bekannte Vorrichtung zur Halterung von Halbleiterscheiben derart weiterzubilden und ein zugehöriges Verwendungsverfahren vorzustellen, damit eine plane Auflage sichergestellt ist.

Diese Aufgabe wird erfindungsgemäß gelöst, durch eine Vorrichtung gemäß Anspruch 1 und ein zugehöriges Verfahren zu deren Verwendung nach Anspruch 10. Bevorzugte Ausführungsformen sind in den abhängigen Ansprüchen beschrieben.

Den Ausgangspunkt der Erfindung bilden bekannte Vorrichtungen der oben genannten Art. Diese weisen eine Oberfläche zur Anordnung einer Halbleiterscheibe auf. Hierbei ist die Dimension der Oberfläche an die zu haltende Halbleiterscheibe angepasst und überragt vorzugsweise die Halbleiterscheibe lateral. Ebenso ist es bevorzugt diese Oberfläche an die Geometrie der Halbleiterscheibe anzupassen, wobei die Oberfläche hierzu eine angepasste Geometrie der Kanäle aufweist. Es ist weiterhin bevorzugt, wenn eine erste Art von Kanälen, die sog. Hauptkanäle konzentrisch um den Mittelpunkt der Oberfläche angeordnet sind. Eine weitere bevorzugte Art von Kanälen sind sog. Stichkanäle, die sich von den Hauptkanälen weg erstrecken, wobei die Richtung des Wegerstreckens der Stichkanäle in gewissen Grenzen beliebig ist.

Für die erfindungsgemäße Ausgestaltung ist es wesentlich, dass die Vorrichtung mindestens drei konzentrisch um einen Mittelpunkt angeordnete Hauptkanäle aufweist, die von der Halbleiterscheibe überdeckbar angeordnet sind und jeder dieser Hauptkanäle mit einer Vakuumpumpeinrichtung verbindbar ist. Vorzugsweise sind diese Hauptkanäle über einzeln ansteuerbare Ventile mit der Vakuumpumpeneinrichtung verbindbar.

Das erfindungsgemäße Verfahren zur Halterung der Halbleiterscheibe mittels der genannten Vorrichtung verbindet die einzelnen Hauptkanäle innen beginnend und nach außen fortschreitend mit der Vakuumpumpeneinrichtung. Somit werden beginnend mit dem Zentrum nach außen fortschreitend weitere konzentrische Bereiche der Halbleiterscheibe mit der planen Oberfläche ohne Verwerfungen verbunden.

Falls mit dieser Vorrichtung Halbleiterscheiben unterschiedlicher Dimensionen verarbeitet werden sollen ist dies besonders einfach, da hierbei die nicht vollständig bedeckten Haupt- und zugeordneten Stichkanäle nicht mit der Vakuumpumpeneinrichtung verbunden werden.

Die erfinderische Lösung wird zudem an Hand der Ausführungsbeispiele der Fig. 1 bis 5 weiter erläutert.

Fig. 1 zeigt eine erste Ausgestaltung einer erfindungsgemäßen Vorrichtung in Draufsicht (Fig. 1a) wie auch im Querschnitt (Fig. 1 b).

Fig. 2 zeigt einen Ausschnitt einer zweiten Ausgestaltung einer erfindungsgemäßen Vorrichtung in Draufsicht.

Fig. 3 zeigt einen Ausschnitt einer dritten Ausgestaltung einer erfindungsgemäßen Vorrichtung in Draufsicht.

Fig. 4 zeigt eine vierte Ausgestaltung einer erfindungsgemäßen Vorrichtung in Draufsicht.

Fig. 5 zeigt eine fünfte Ausgestaltung einer erfindungsgemäßen Vorrichtung in Draufsicht.

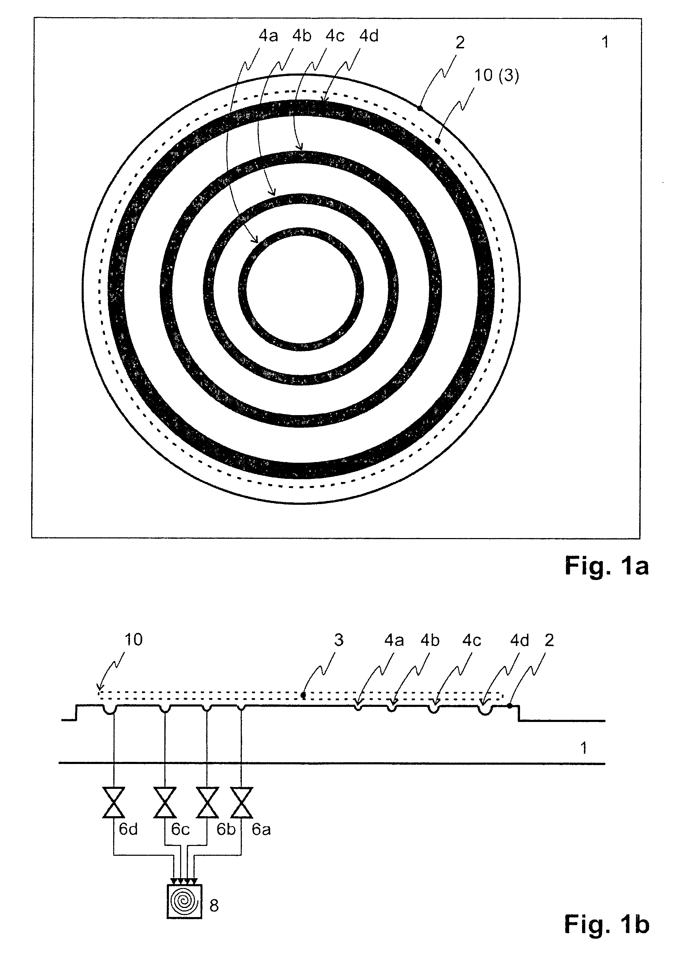

Fig. 1 zeigt eine erste Ausgestaltung einer erfindungsgemäßen Vorrichtung (1) in Draufsicht (Fig. 1a) wie auch im Querschnitt (Fig. 1 b) entlang der Schnittlinie A-A. Dargestellt ist hier eine plane, scheibenförmige Oberfläche (2) der Vorrichtung (1) sowie der Rand (10) einer hierauf anordenbaren und dort zu haltenden Halbleiterscheibe. Die Vorrichtung (1) weist weiterhin vier konzentrisch um den Mittelpunkt der Oberfläche (2) angeordnete kreisförmige Hauptkanäle (4 a/b/c/d) auf, deren Querschnitt vorzugsweise kreissegmentförmig ist.

Der innerste (4a) dieser Hauptkanäle (4 a/b/c/d) weist sowohl die geringste Breite, wie auch die geringste Tiefe auf. Es kann auch bevorzugt sein nur eine oder keine der beiden Dimensionen von innen nach außen zu verändern. Ebenso kann der laterale Abstand der einzelnen Hauptkanäle (4 a/b/c/d) zueinander variabel ausgestaltet sein.

Jeder der vier Hauptkanäle (4 a/b/c/d) ist, schematisch dargestellt in Fig. 1b, über ein eigenes ihm zugeordnetes Ventil (6 a/b/c/d) mit einer Vakuumpumpeneinrichtung (8) verbunden. Erfindungsgemäß wird, nachdem eine Halbleiterscheibe auf der Oberfläche (2) angeordnet ist, zuerst der innerste Hauptkanal (4a) mit der Vakuumpumpeneinrichtung (8) verbunden, wodurch die Halbleiterscheibe eine erste Grundhalterung erfährt. Anschließend wird, ohne die Verbindung mit dem innersten Hauptkanal (4a) zu unterbrechen, der zweite Hauptkanal (4b) mit der Vakuumpumpeneinrichtung (8) verbunden.

Nachdem der dritte (4c) und anschließend der vierte (4d) Hauptkanal mit der Vakuumpumpeneinrichtung (8) verbunden wurden ist die Halterung der Halbleiterscheibe vollständig hergestellt und diese kann nun bearbeitet werden. Durch das von innen nach außen fortschreitende Verbinden der Hauptkanäle (4 a/b/c/d) mit der Vakuumpumpeneinrichtung (8) wird erreicht, dass die Halbleiterscheibe plan, ohne Verwerfungen, auf der Oberfläche (2) der Vorrichtung (1) aufliegt.

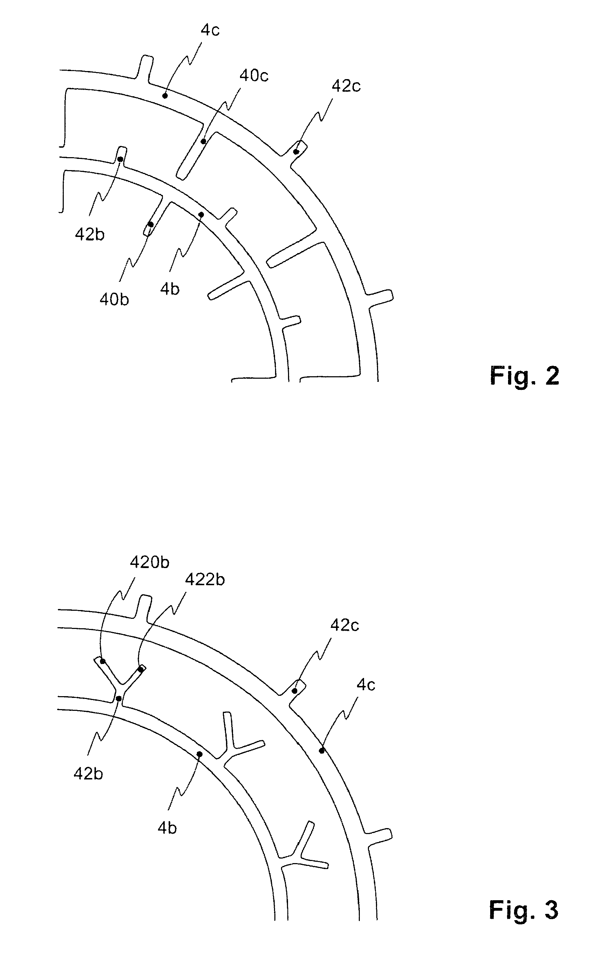

Fig. 2 zeigt einen Ausschnitt einer zweiten Ausgestaltung einer erfindungsgemäßen Vorrichtung (1) in Draufsicht. Dargestellt sind hierbei nur zwei Hauptkanäle (4 b/c) mit radial nach außen (42 b/c) und innen (40 b/c) hiervon sich weg erstreckenden Stichkanälen. Diese Stichkanäle (40 b/c, 42 b/c) verbessern die Haftung der Halbleiterscheibe auf der Oberfläche (2) der Vorrichtung (1) weiter. Es kann auch bevorzugt sein wenn sich Stichkanäle (40c) eines Hauptkanals (4c) zwischen die Stichkanäle (42b) eines benachbarten Hauptkanals (4b) fingerartig hinein erstrecken, selbstverständlich ohne ein Verbindung der beiden Hauptkanäle (4 b/c) herzustellen.

Die Stichkanäle (40, 42) wiesen vorzugsweise die gleiche kreissementartige Querschnittsfläche wie die Hauptkanäle (4) auf. Es ist weiterhin bevorzugt, wenn die Stichkanäle (40, 42) eine geringer Breite oder auch eine geringere Tiefe aufweisen als der zugeordnete Hauptkanal (4).

Fig. 3 zeigt einen Ausschnitt einer dritten Ausgestaltung einer erfindungsgemäßen Vorrichtung (1) in Draufsicht. Vergleichbar mit Fig. 3 erstrecken sich in dieser Ausgestaltung Stichkanäle (42c) eines Hauptkanals (4c) radial nach außen, während die Stichkanäle (42b) eines weitern Hauptkanals (4b) sich in ihrem Verlauf radial nach außen erstrecken und sich dort weiter verzweigen (420b, 422b).

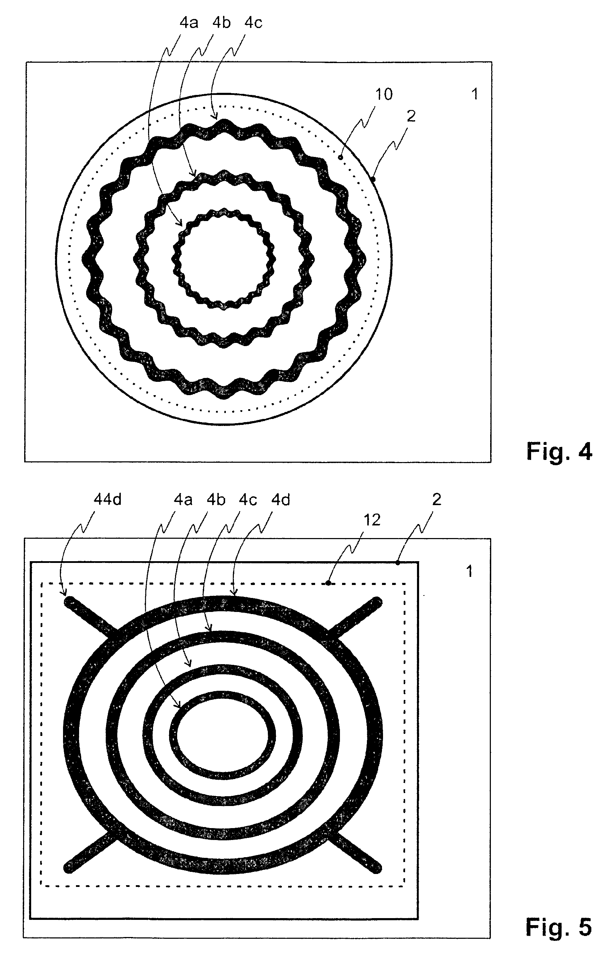

Fig. 4 zeigt eine vierte Ausgestaltung einer erfindungsgemäßen Vorrichtung (1) in Draufsicht. Hierbei sind die Hauptkanäle (4) ähnlich wie unter Fig. 1 konzentrisch um einen gemeinsamen Mittelpunkt angeordnet. Allerdings sind die Hauptkanäle (4) dieser Ausgestaltung in sich wellenförmig ausgebildet was sich weiter positiv für die plane Halterung der Halbleiterscheibe auf der Oberfläche (2) der Vorrichtung (1) auswirkt.

Fig. 5 zeigt eine fünfte Ausgestaltung einer erfindungsgemäßen Vorrichtung (1) in Draufsicht speziell für rechteckige, oder prinzipiell auch quadratische, Halbleiterscheiben, deren Rand (12) ebenfalls dargestellt ist. Hierbei weisen die beiden inneren Hauptkanäle (4 a/b) die grundsätzlich einfache Ausgestaltung wie unter Fig. 1 beschrieben auf, während der äußere Hauptkanal (4c) vier Stichkanäle (44d) aufweist, die sich radial in Richtung der Ecken der Oberfläche der Vorrichtung erstrecken. Allerdings ist die Grundform der Hauptkanäle (4 a/b/c/d) hier ellipsenförmig. Zur weiteren Verbesserung der Planlage können hier wie auch allgemein weitere bisher genannte Ausgestaltungen der Haupt- und Stichkanäle mit dieser Ausgestaltung kombiniert werden.

## Patentansprüche

1. Vorrichtung (1) zur Halterung einer runden oder rechteckigen Halbleiterscheibe mit einer an die Dimensionen dieser Halbleiterscheibe angepassten planen Oberfläche (2), wobei diese Oberfläche (2) mindestens drei konzentrisch angeordnete Hauptkanäle (4 a/b/c/d) aufweist, die von der Halbleiterscheibe überdeckbar angeordnet sind und wobei jeder dieser Hauptkanäle (4 a/b/c/d) unabhängig von den anderen Hauptkanälen mit einer Vakuumpumpeinrichtung (8) verbindbar ist.

2. Vorrichtung nach Anspruch 1,
wobei die Hauptkanäle (4 a/b/c/d) über einzeln ansteuerbare Ventile (6 a/b/c/d) mit der Vakuumpumpeneinrichtung (8) verbindbar sind.

3. Vorrichtung nach Anspruch 1,
wobei die Hauptkanäle (4 a/b/c/d) kreisförmig, ellipsenförmig oder wellenartig ausgebildet sind und konzentrisch um einen Mittelpunkt angeordnet sind.

4. Vorrichtung nach Anspruch 1,
wobei die Hauptkanäle (4 a/b/c/d) jeweils eine Mehrzahl von Stichkanälen (40, 42) aufweisen, die radial in Richtung eines benachbarten Hauptkanals reichen.

5. Vorrichtung nach Anspruch 1,
wobei die Breite und / oder Tiefe der Hauptkanäle (4 a/b/c/d) von innen nach außen zunimmt.

6. Vorrichtung nach Anspruch 5,
wobei die Stichkanäle (40, 42) benachbarter Hauptkanäle (4 a/b/c/d) fingerartig in die Zwischenräume von Stichkanälen eines benachbarten Hauptkanals greifen.

7. Vorrichtung nach Anspruch 5,
wobei die Stichkanäle (40, 42) eine geringer Breite und / oder Tiefe aufweisen als die zugeordneten Hauptkanäle (4).

8. Vorrichtung nach Anspruch 5,
wobei die Stichkanäle (40, 42) weitere Verzweigungen (420, 422) aufweisen.

9. Vorrichtung nach Anspruch 1 oder 5,
wobei die Haupt- (4) oder Stichkanäle (40, 42) kreissegmentartige Querschnitte aufweisen.

10. Verfahren zur Verwendung einer Vorrichtung (1) nach einem der vorhergehenden Ansprüche,
wobei zur Halterung der Halbleiterscheibe die Hauptkanäle (4) beginnend mit dem dem Mittelpunkt nächstgelegenen Hauptkanal (4a) mit der Vakuumpumpeinrichtung (8) verbunden wird und im Weiteren der jeweils nächstliegenden Hauptkanal (4) mit der Vakuumpumpeinrichtung (8) verbunden wird bis alle Hauptkanäle (4) mit der Vakuumpumpeneinrichtung (8) verbunden sind und somit die Halbleiterscheibe innen beginnen und nach außen fortschreitend auf der Oberfläche (2) der Vorrichtung (1) gehalten wird.
